(19) Europäisches Patentamt
European Patent Office
Office européen des brevets

(11) **EP 4 375 682 A1**

(12) **EUROPEAN PATENT APPLICATION**
published in accordance with Art. 153(4) EPC

(43) Date of publication:
**29.05.2024 Bulletin 2024/22**

(21) Application number: **22871530.6**

(22) Date of filing: **30.06.2022**

(51) International Patent Classification (IPC):
**G01R 23/02** (2006.01)

(52) Cooperative Patent Classification (CPC):
**G01R 23/02; H02J 3/24; H02J 3/38; H02J 3/48;**
**Y02E 10/76**

(86) International application number:
**PCT/CN2022/102858**

(87) International publication number:
**WO 2023/045469 (30.03.2023 Gazette 2023/13)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **27.09.2021 CN 202111136677**

(71) Applicant: **GOLDWIND SCIENCE & TECHNOLOGY**
**CO., LTD.**
**Xinjiang 830026 (CN)**

(72) Inventors:
- **CAO, Xiaodong**
**Beijing 100176 (CN)**
- **LIU, Shijun**
**Beijing 100176 (CN)**

(74) Representative: **Gulde & Partner**
**Patent- und Rechtsanwaltskanzlei mbB**
**Wallstraße 58/59**
**10179 Berlin (DE)**

(54) **POWER GRID FREQUENCY DETECTION METHOD, APPARATUS, POWER GRID FREQUENCY ADJUSTMENT METHOD, AND APPARATUS**

(57) A power grid frequency detection method, an apparatus, a power grid frequency adjustment method, and an apparatus. The power grid frequency detection method comprises: transforming a collected three phase voltage of a grid connection point to a two phase voltage (S101); performing transformation on the two phase voltage on the basis of a phase of a specified frequency, and obtaining a voltage negative sequence component and a voltage positive sequence component to be decoupled (S102); performing decoupling on the voltage negative sequence component and the voltage positive sequence component to be decoupled on the basis of said phase, performing filtering on the decoupled voltage positive sequence component, and obtaining a voltage positive sequence fundamental component (S103); performing inverse transformation on the voltage positive sequence fundamental component on the basis of said phase, and obtaining a set of orthogonal voltage components in a two phase stationary coordinate system (S104); obtaining a phase of the power grid on the basis of the set of orthogonal voltage components (S105); and obtaining a frequency of the power grid on the basis of the phase of the power grid (S106).

**Figure 1**

## Description

### TECHNICAL FIELD

The present disclosure generally relates to the field of power technology, and in particular to a method and apparatus for detecting a power grid frequency, and a method and apparatus for regulating a power grid frequency.

### BACKGROUND

The functions of inertia response and primary frequency regulation are required for connecting a wind farm to a power grid. A large wind turbine is connected to the power grid through an inverter, and has an advantages of flexible control and fast response as compared to a synchronous generator (e.g., generators for thermal power and a hydropower) for the traditional power grid. At present, a method for the wind turbine to participate in inertia support and power grid frequency regulation mainly includes a method for controlling kinetic energy of a rotor and a method for controlling a standby power. Detecting the power grid frequency with high-precision is a foundation for achieving inertia response and primary frequency regulation.

### SUMMARY

Embodiments of the present disclosure are to provide a method and an apparatus for detecting a power grid frequency and a method and an apparatus for regulating a power grid frequency that can conveniently, quickly, and accurately detect the power grid frequency and effectively regulate the power grid frequency.

According to a first aspect of embodiments of the present disclosure, a method for detecting a power grid frequency is provided. The method includes: converting a collected three-phase voltage at a point of common coupling into a two-phase voltage; transforming the two-phase voltage based on a phase angle of a specific frequency to obtain a positive sequence component to be decoupled and a voltage negative sequence component to be decoupled; decoupling the voltage positive sequence component to be decoupled and the voltage negative sequence component to be decoupled based on the phase angle, and filtering a decoupled voltage positive sequence component to obtain a voltage positive sequence fundamental component; performing inverse transformation on the voltage positive sequence fundamental component based on the phase angle to obtain a set of orthogonal voltage components in a two-phase stationary coordinate system; obtaining a phase angle of a power grid based on the set of orthogonal voltage components; and obtaining a power grid frequency based on the phase angle of the power grid.

According to a second aspect of embodiments of the present disclosure, a method for regulating a power grid frequency is provided. The method includes: determining whether there is a disturbance in an amplitude of a three-phase voltage at a point of common coupling; determining whether a response condition for power grid frequency regulation is met based on a detected power grid frequency and/or a change rate of the power grid frequency when there is no disturbance; controlling a power of a wind turbine based on the power grid frequency and/or the change rate of the power grid frequency to regulate the power grid frequency when the response condition for power grid frequency regulation is met; and where the power grid frequency and/or the change rate of the power grid frequency are obtained by performing the method for detecting a power grid frequency as described above.

According to a third aspect of embodiments of the present disclosure, an apparatus for detecting a power grid frequency is provided. The apparatus includes: a two-phase voltage acquisition unit configured to convert a collected three-phase voltage at a point of common coupling into a two-phase voltage; a transformation unit configured to transform the two-phase voltage based on a phase angle of a specific frequency to obtain a voltage positive sequence component to be decoupled and a voltage negative sequence component to be decoupled; a decoupling and filtering unit configured to decouple the voltage positive sequence component to be decoupled and the voltage negative sequence component to be decoupled based on the phase angle, and to filter a decoupled voltage positive sequence component to obtain a voltage positive sequence fundamental component; an inverse transformation unit configured to perform inverse transformation on the voltage positive sequence fundamental component based on the phase angle to obtain a set of orthogonal voltage components in a two-phase stationary coordinate system; a power grid phase angle acquisition unit configured to obtain a phase angle of the power grid based on the set of orthogonal voltage components; and a power grid frequency acquisition unit configured to obtain the power grid frequency based on the phase angle of the power grid.

According to a fourth aspect of embodiments of the present disclosure, an apparatus for regulating a power grid frequency is provided. The apparatus includes: a voltage disturbance determination unit configured to determine whether there is a disturbance in an amplitude of a three-phase voltage at a point of common coupling; a response condition determination unit configured to determine whether a response condition for power grid frequency regulation is met based on a detected power grid frequency and/or a change rate of the power grid frequency when there is no disturbance; a power grid frequency regulation unit configured to control a power of a wind turbine based on the grid frequency and/or the change rate of the power grid frequency to regulate the power grid frequency when the response condition for power grid frequency regulation is met; and where the power grid frequency and/or the change rate of the power grid frequency are obtained through the apparatus for detecting a power grid frequency as described above.

According to a fifth aspect of embodiments of the present disclosure, a computer-readable storage medium storing a computer program is provided. The computer program, when executed by a processor, causes the processor to perform the method for detecting a power grid frequency as described above and/or the method for regulating a power grid frequency as described above.

According to a sixth aspect of embodiments of the present disclosure, an electronic device is provided. The electronic device includes: a processor; a memory, storing a computer program, where the computer program, when executed by the processor, causes the processor to perform the method for detecting a power grid frequency as described above and/or the method for regulating a power grid frequency as described above.

The technical solution provided in the embodiments of the present disclosure at least has the following beneficial effects.

The power grid frequency and the change rate thereof can be detected with high-precision and high response speed, so that the detection accuracy of the power grid frequency and the change rate thereof meets the required technical indicators, and the time for detecting the power grid frequency and the change rate thereof becomes short. Moreover, it has a good power grid imbalance adaptability, harmonics adaptability, voltage offset adaptability, and frequency offset adaptability .

The problem of the misresponse of the inertia and the primary frequency regulation caused by the disturbance generated during the switching of the filter capacitor, sudden power increase, high-voltage ride-through, and low-voltage ride-through in detecting the power grid frequency and the change rate thereof based on the three-phase voltage signal of the power grid can be solved;

The method for detecting a power grid frequency and the method for regulating a power grid frequency according to the present disclosure can be implemented without adding additional hardware to the wind turbine, thereby achieving rapid development, application of new models, and on-site modification.

The oscillation problem of the change rate of the power grid frequency and the active support due to the disturbance of the inertia response for the wind turbine during the active support on the frequency detection is solved.

The active power increment is calculate based on the detected power grid frequency and the change rate thereof in combination with the virtual inertia equation, and the active power increment is converted into a motor control torque command to complete power control, and thus achieve the inertia response and primary frequency regulation of the wind turbine.

Additional aspects and/or advantages of the overall concept of the present disclosure are partially explained in the following description. The other parts of the present disclosure will be clear through the description or can be learned through implementations of the overall concept of the present disclosure.

## BRIEF DESCRIPTION OF THE DRAWINGS

The above and other objectives and features of embodiments of the present disclosure become more apparent from the following description in conjunction with the drawings that exemplarily illustrate the embodiments. In the drawings:

Figure 1 shows a flowchart of a method for detecting a power grid frequency according to an embodiment of the present disclosure;

Figure 2 shows an example of a method for detecting a power grid frequency according to an embodiment of the present disclosure;

Figure 3 shows a flowchart of a method for regulating a power grid frequency according to an embodiment of the present disclosure;

Figure 4 shows a flowchart of a method for regulating a power grid frequency according to another embodiment of the present disclosure;

Figure 5 shows an example of an inertia response test according to an embodiment of the present disclosure;

Figure 6 shows an example of a primary frequency regulation test according to an embodiment of the present disclosure;

Figure 7 shows a structural block diagram of an apparatus for detecting a power grid frequency according to an embodiment of the present disclosure; and

Figure 8 shows a structural block diagram of an apparatus for regulating a power grid frequency according to an embodiment of the present disclosure.

## DETAILED DESCRIPTION OF THE EMBODIMENTS

Reference is made in detail to embodiments of the present disclosure. Examples of the embodiments are illustrated in the drawings, where same reference numerals represent same components. The embodiments are illustrated hereinafter with reference to the drawings to explain the present disclosure.

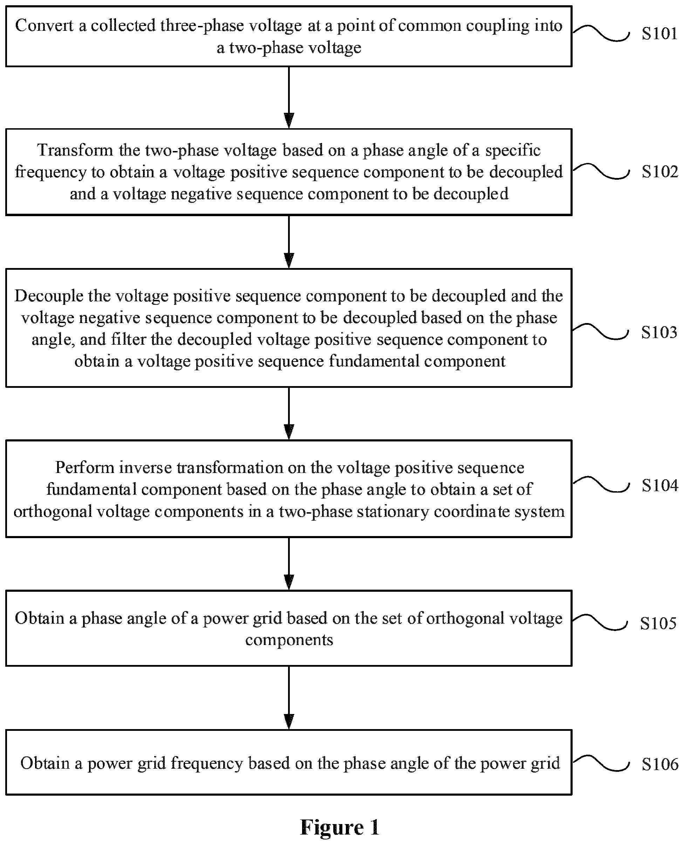

Figure 1 shows a flowchart of a method for detecting a power grid frequency according to an embodiment of the present disclosure. As an example, the method for detecting a power grid frequency can be performed by a converter (such as a controller of the converter) of a wind turbine. As an example, the method for detecting a power grid frequency can be performed periodically according to a preset detection cycle T of a power grid frequency.

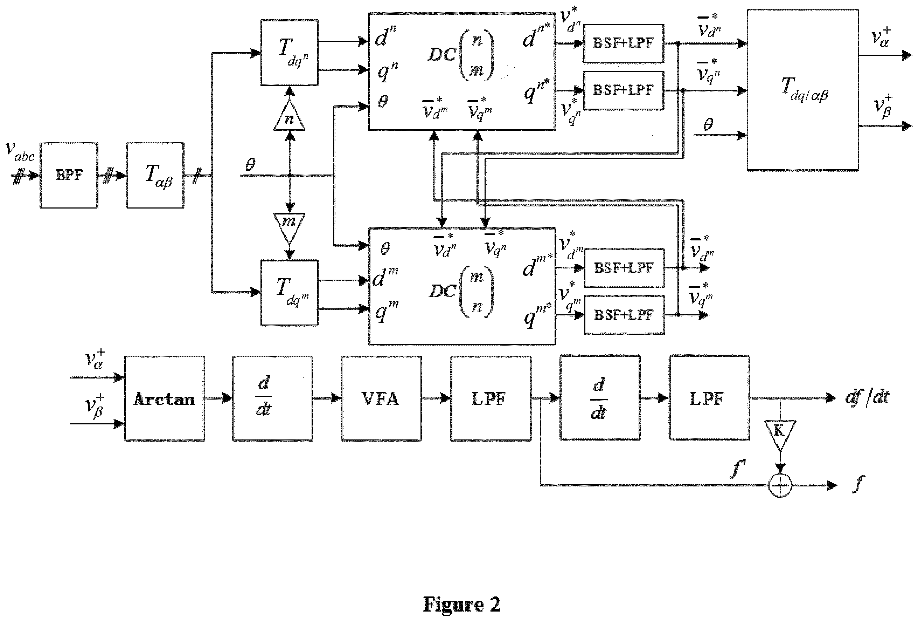

Referring to Figure 1 and in combination with Figure 2, in step S101, a collected three-phase voltage at a point of common coupling is converted into a two-phase voltage.

As an example, the method for detecting a power grid frequency according to the embodiment of the present disclosure may further include: collecting a three-phase voltage at a point of common coupling with a high frequency to achieve high-precision and high response speed requirements for detecting a power grid frequency and a change rate thereof.

For example, the collected three-phase voltages $v_a$, $v_b$, and $v_c$ (for convenience of description, the three-phase voltages are represented by $v_{abc}$) at the point of common coupling may be filtered first. Then, Clark equiamplitude transformation (for example, $T_{\alpha\beta}$ in Figure 2 represents a Clark transformation matrix) is performed on the filtered three-phase voltage to obtain a two-phase voltage to achieve dimensionality reduction. As an example, band-pass filtering (for example, BPF in Figure 2 represents a band-pass filter) may be performed on the collected three-phase voltage at the point of common coupling. For example, a center frequency of the band-pass filtering may be a rated frequency of a power grid or a power grid frequency detected during a previous detection period of a power grid frequency (i.e., a power grid frequency detected during the previous detection period of the power grid frequency by performing the method for detecting a power grid frequency according to an embodiment of the present disclosure). The main function of band-pass filtering is to filter high-frequency stray signals, all integer harmonics, and subsynchronous harmonics out of a three-phase voltage sampling signal, in order to obtain a relatively pure voltage fundamental component.

As an example, a three-phase voltage digital signal collected with a high frequency may be filtered by a digital band-pass filter, where a center frequency of the band-pass filter may be adaptively adjusted based on an instantaneous frequency of the power grid detected through the method for detecting a power grid frequency or may be fixed to a rated frequency of the power grid. The main function of the filter is to filter high-frequency stray signals, all integer harmonics, and subsynchronous harmonics out of a three-phase voltage sampling signal, in order to obtain a relatively pure voltage fundamental component. For example, the band-pass filter may be implemented through a hardware circuit, or may be obtained by subtracting a value of an original signal filtered by a band-stop filter from an original signal, or may be implemented through a low-pass filter plus a high-pass filter. The implementation of the band-pass filter is not limited in the present disclosure.

In step S102, the two-phase voltage is transformed based on a phase angle of a specific frequency to obtain a voltage positive sequence component to be decoupled and a voltage negative sequence component to be decoupled.

As an example, the phase angle $\theta$ may be obtained by integrating a specific angular velocity, wherein a frequency corresponding to the specific angular velocity is the specific frequency. Specifically, a phase angle (i.e., the phase angle) used in a current detection cycle of the power grid frequency is an angle obtained by superimposing T*w to a phase angle used in a previous detection cycle of the power grid frequency, where T is a length of the detection cycle of the power grid frequency and w is the specific angular velocity (i.e., $2\pi f$, wherein f is the specific frequency). For example, when the angle exceeds $2\pi$, $2\pi$ may be subtracted to keep the phase angle always within a range of 0 to $2\pi$.

As an example, the specific angular velocity may be a rated angular velocity of the power grid (i.e., the specific frequency is the rated frequency of the power grid). It should be understood that the specific angular velocity may also be another fixed angular velocity. For example, a frequency corresponding to the fixed angular velocity needs to be greater than a cut-off frequency of a LPF in a "BSF+LPF" module shown in Figure 2, in order to improve the accuracy of the power grid frequency calculation.

The rapidity and stability of the power grid frequency detection can be improved by using the method for obtaining the phase angle above, in order to avoid affecting a response time for detecting the power grid frequency and the change rate thereof, and the stability under special working conditions.

For example, the phase angle may be used to perform Park transformation on the two-phase voltage obtained by the Clark equiamplitude transformation to obtain a voltage positive sequence component to be decoupled and a voltage negative sequence component to be decoupled.

Specifically, as an example, positive and negative sequence rotation coordinate transformation may be performed on the two-phase voltage based on the phase angle, to obtain a voltage positive sequence component to be decoupled in a positive sequence rotation coordinate system and a voltage negative sequence component to be decoupled in a negative sequence rotation coordinate system. The positive sequence rotation coordinate system and the negative sequence rotation coordinate system form a dual synchronous rotation coordinate system. For example, $T_{dq}$ in Figure 2 represents a Park transformation matrix.

In step S103, the voltage positive sequence component to be decoupled and the voltage negative sequence component to be decoupled are decoupled based on the phase angle, and the decoupled voltage positive sequence component is filtered to obtain a voltage positive sequence fundamental component.

As an example, the method for detecting a power grid frequency according to the embodiment of the present disclosure may further include: filtering the decoupled voltage negative sequence component to obtain a voltage negative sequence fundamental component.

As an example, based on the phase angle, the voltage negative sequence fundamental component obtained from the previous detection cycle of the power grid frequency can be used to perform cross feedback decoupling on the voltage positive sequence component to be decoupled, to obtain a decoupled voltage positive sequence component (including a positive sequence voltage d-axis component and a positive sequence voltage q-axis component decoupled). And based on the phase angle, the voltage positive sequence fundamental component obtained from the previous detection cycle of the power grid frequency is used to perform cross feedback decoupling on the voltage negative sequence component to be decoupled, to obtain a decoupled voltage negative sequence component (including a negative sequence voltage d-axis component and a negative sequence voltage q-axis component decoupled).

As an example, in an example of cross feedback decoupling shown in Figure 2, $n$ represents a number of positive sequence components, $m$ represents a number of negative sequence components, $d^n$ represents the $n^{th}$ of positive sequence d-axis components, $q^n$ represents $n^{th}$ of positive sequence q-axis components, $d^m$ represents the $m^{th}$ of negative sequence d-axis components, $q^m$ represents the $m^{th}$ of negative sequence q-axis components, $d^{n*}$ represents decoupled the $n^{th}$ of positive sequence d-axis components, $q^{n*}$ represents decoupled the $n^{th}$ of positive sequence q-axis components, $d^{m*}$ represents decoupled the $m^{th}$ of negative sequence d-axis components, $q^{m*}$ represents decoupled the $m^{th}$ of negative sequence q-axis components; $v_{d^n}^*$ represents the $n^{th}$ of positive sequence voltage d-axis components; $v_{q^n}^*$ represents the $n^{th}$ of positive sequence voltage q-axis components, $v_{d^m}^*$ represents the $m^{th}$ of negative sequence voltage d-axis components, $v_{q^m}^*$ represents the $m^{th}$ of negative sequence voltage q-axis components, and $DC\begin{pmatrix} n \\ m \end{pmatrix}$ represents a positive sequence and negative sequence decoupling network.

For example, the positive sequence component and the negative sequence component decoupled may be calculated based on equations (1) and (2). If only the fundamental component is considered, then let n = 1 and $m$ = -1. For example, the voltage positive sequence component and the voltage negative sequence component obtained from Park transformation may be decoupled based on equations (1) and (2). For example, the values of m and n may be set to other values based on the calculation performance of a controller. The larger the value is, the more accurate the calculation is.

$$v_{dq^n}^* = \begin{bmatrix} v_{d^n}^* \\ v_{q^n}^* \end{bmatrix} = \begin{bmatrix} v_{d^n} \\ v_{q^n} \end{bmatrix} + \overline{v}_{d^m}^* \begin{bmatrix} \cos(n-m)\theta \\ -\sin(n-m)\theta \end{bmatrix} + \overline{v}_{q^m}^* \begin{bmatrix} \sin(n-m)\theta \\ \cos(n-m)\theta \end{bmatrix} \qquad (1)$$

$$v_{dq^m}^* = \begin{bmatrix} v_{d^m}^* \\ v_{q^m}^* \end{bmatrix} = \begin{bmatrix} v_{d^m} \\ v_{q^m} \end{bmatrix} + \overline{v}_{d^n}^* \begin{bmatrix} \cos(n-m)\theta \\ \sin(n-m)\theta \end{bmatrix} + \overline{v}_{q^n}^* \begin{bmatrix} -\sin(n-m)\theta \\ \cos(n-m)\theta \end{bmatrix} \qquad (2)$$

As an example, band-stop BSF filtering and low-pass LPF filtering may be performed on the decoupled voltage positive sequence component to obtain a voltage positive sequence fundamental component. Correspondingly, as an example, band-stop BSF filtering and low-pass LPF filtering may be performed on the decoupled voltage negative sequence component to obtain a voltage negative sequence fundamental component. For example, a center frequency of band-stop filtering may be a rated frequency of the power grid or a power grid frequency detected during a previous detection cycle of the power grid frequency, and be used to filter out positive sequence second harmonics in the power grid, positive sequence second harmonics closer to a power grid fundamental frequency, and high-frequency interference signals generated by a negative sequence voltage to a positive sequence voltage. For example, the specific frequency may be higher than the cut-off frequency of the low-pass filter here. Low-pass filtering can filter out the influence of the negative sequence component on the positive sequence component and other high-frequency signals, in order to obtain a positive sequence fundamental d-axis component and a positive sequence fundamental q-axis component.

For example, as shown in Figure 2, the "BSF+LPF" module represents a band-stop filter and a low-pass filter. $\overline{v}^{*}_{d^n}$ represents the $n^{th}$ of positive sequence voltage d-axis components after filtered, $\overline{v}^{*}_{q^n}$ represents the $n^{th}$ of positive sequence voltage q-axis components after filtered, $\overline{v}^{*}_{d^m}$ represents the $m^{th}$ of negative sequence voltage d-axis components after filtered, and $\overline{v}^{*}_{q^m}$ represents the $m^{th}$ of negative sequence voltage q-axis components after filtered.

In step S104, an inverse transformation is performed on the voltage positive sequence fundamental component based on the phase angle to obtain a set of orthogonal voltage components in a two-phase stationary coordinate system.

For example, as shown in Figure 2, an inverse Park transform may be performed on the d-axis component and q-axis component of the positive sequence fundamental based on the phase angle $\theta$ to obtain a set of orthogonal signals $v^{+}_{\alpha}$ and $v^{+}_{\beta}$, where $T_{dq/a\beta}$ represents an inverse Park transform matrix, $v^{+}_{\alpha}$ represents a $\alpha$-axis component of a stationary coordinate system, and $v^{+}_{\beta}$ represents a $\beta$-axis component of a stationary coordinate system.

In step S105, a phase angle of the power grid is obtained based on the set of orthogonal voltage components.

As an example, arctangent or arc cotangent of the orthogonal voltage component may be calculated to obtain the phase angle of the power grid. For example, a value of Arctan $v_{\alpha}/v_{\beta}$ may be used as the phase angle of the power grid.

In step S106, a power grid frequency is obtained based on the phase angle of the power grid.

For example, the method for detecting a power grid frequency according to the embodiment of the present disclosure may further include obtaining a change rate of the power grid frequency based on the phase angle of the power grid.

As an example, the power grid frequency may be obtained by performing differential calculation (for example, $\frac{d}{dt}$ shown in Figure 2 represents a differentiator) on the phase angle of the power grid. For example, in order to further eliminate integer harmonics, an adaptive dynamic sliding window filter (e.g., VFA shown in Figure 2 represents an adaptive dynamic sliding window filter) can be used to filter the calculated power grid frequency. The change rate of the power grid frequency is calculated by differentiating the filtered power grid frequency. For example, a low-pass filter (e.g., LPF shown in Figure 2 represents a low-pass filter) can be used to filter the calculated change rate of the frequency, and a filtering result may be used as the final detected change rate $_{df/dt}$ of the power grid frequency.

As an example, differential calculation may be first performed on the phase angle of the power grid to obtain a first frequency. Then, the first frequency is filtered to obtain a second frequency. Next, the power grid frequency is obtained based on the second frequency. For example, adaptive dynamic sliding window filtering and/or low-pass filtering may be performed on the first frequency.

As an example, differential calculation may be performed on the second frequency to obtain a change rate of the second frequency, and the change rate of the second frequency is filtered to obtain a change rate of the power grid frequency. For example, low-pass filtering may be performed on the change rate of the second frequency.

As an example, a product of the change rate of the power grid frequency and a frequency compensation coefficient K may be superimposed onto the second frequency, and a superimposed result may be used as the final detected power grid frequency $f$. Compensating the power grid frequency based on the detected change rate of the power grid frequency can further improve the accuracy and response time of the power grid frequency detection. It should be understood that the detected power grid frequency may be compensated by using other methods, which is not limited in the present disclosure. For example, the detected power grid frequency may be compensated by adding a fixed value.

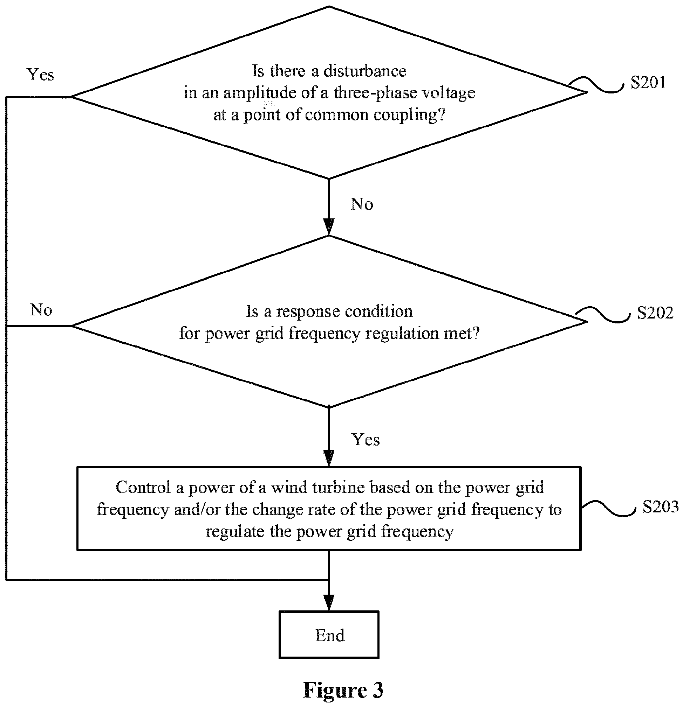

Figure 3 shows a flowchart of a method for regulating a power grid frequency according to an embodiment of the present disclosure. As an example, the method for regulating a power grid frequency can be applied to a direct-drive wind turbine and/or a semi-direct-drive wind turbine for regulating the power grid frequency. For example, the method for regulating a power grid frequency may be performed by a converter (such as a controller of the converter) of a wind turbine.

Referring to Figure 3, in step S201, it is determined whether there is a disturbance in an amplitude of a three-phase voltage at a point of common coupling.

As an example, it is determined whether there is a disturbance in the amplitude of the three-phase voltage at the point of common coupling, based on the decoupled voltage positive sequence component and the voltage positive sequence fundamental component obtained by filtering the decoupled voltage positive sequence component. The decoupled voltage positive sequence component and the filtered voltage positive sequence fundamental component are obtained by performing the method for detecting a power grid frequency described with reference to Figure 1.

For example, an amplitude of a high-frequency signal in the decoupled voltage positive sequence component may be obtained based on the decoupled voltage positive sequence component and the filtered voltage positive sequence fundamental component. When the amplitude of the high-frequency signal is greater than a preset threshold, it is determined that there is a disturbance in the amplitude of the three-phase voltage at the point of common coupling.

It is considered in the present disclosure that there may be a high-frequency signal in $v_{d^n}^*$ and $v_{q^n}^*$ when the disturbance occurs, but, $\overline{v}_{d^n}^*$ and $\overline{v}_{q^n}^*$ contains no high-frequency signal because they are obtained by filtering $v_{d^n}^*$ and $v_{q^n}^*$. Therefore, the amplitude of the high-frequency signal may be obtained by calculating the amplitude of pre-filtered and post-filtered signals to thereby determine whether the disturbance occurs. As an example, equations (3) or (4) can be used to calculate the amplitude $\delta$ of the high-frequency signal in the decoupled voltage positive sequence component. It should be understood that there are various methods for calculating a disturbance component (such as a high-frequency component) using four variables of $v_{d^n}^*$, $v_{q^n}^*$, $\overline{v}_{d^n}^*$ and $\overline{v}_{q^n}^*$, which is not limited in the present disclosure. The influence of a low-frequency component in the signal on the calculation of a high-frequency component can effectively avoided by using the provided equation (3).

$$\delta = \sqrt{\left(\overline{v}_{d^n}^* - v_{d^n}^*\right)^2 + \left(\overline{v}_{q^n}^* - v_{q^n}^*\right)^2} \qquad (3)$$

A disturbance amount may be calculated by using equation (3) so that a high-frequency disturbance component can be effectively extracted while avoiding the influence of a low-frequency component on the calculation. In addition, the calculation may also be carried out according to equation (4).

$$\delta' = \sqrt{\left(v_{d^n}^* + v_{q^n}^*\right)^2 - \left(\overline{v}_{d^n}^* + \overline{v}_{q^n}^*\right)^2} \qquad (4)$$

A disturbance amount may be calculated by using equation (3) so that a high-frequency disturbance component can be effectively extracted while avoiding the influence of a low-frequency component on the calculation. The calculation may also be carried out according to equation (4) or using other variants of the four variables in equation (3).

It is considered in the present disclosure a change and fluctuation in the three-phase voltage at the point of common coupling caused by the switching of a filter capacitor can cause a disturbance in the detection of the frequency and the change rate thereof. This is because the method for detecting a power grid frequency according to the present disclosure is based on the three-phase voltage at the point of common coupling t. Therefore, when some actions of the wind turbine cause a fluctuation and disturbance in the voltage at the point of common coupling, it will cause a disturbance in the detection of the power grid frequency. However, in reality, this disturbance is not a disturbance in the frequency of the power grid itself, but rather a disturbance presented in the detected power grid frequency caused by the disturbance of the voltage at the point of common coupling of the wind turbine. It is a disturbance in a detection value of the frequency caused by an abnormal fluctuation (including the switching of a filter capacitor, and high-voltage ride-through and low-voltage ride-through, etc.) in the voltage amplitude at the grid- connected point of the wind turbine, that is, a disturbance in the detection of the frequency caused by an amplitude fluctuation in the voltage at the point of common coupling.

When it is determined in step S201 that there is no disturbance, step S202 is performed to determine whether a response condition for power grid frequency regulation is met based on a detected power grid frequency and/or a change rate of the power grid frequency.

The power grid frequency and/or the change rate of the power grid frequency are detected by performing the method for detecting a power grid frequency described with reference to Figure 1.

It should be understood that, the method for detecting a power grid frequency described with reference to Figure 1 may be performed first, and then the method for regulating a power grid frequency described with reference to Figure 3 may be performed. Specifically, step S201 may be performed based on intermediate variables (such as the decoupled voltage positive sequence component and the filtered voltage positive sequence fundamental component) in the process of detecting a power grid frequency this time. When it is determined that there is no disturbance, steps S202 and S203 are performed based on a detection result of the power grid frequency this time (i.e., the power grid frequency and the change rate thereof).

When there is a disturbance in the amplitude of the three-phase voltage at the grid-connected point (caused by such as the switching of a filter capacitor, high-voltage ride-through and low-voltage ride-through, etc.), a disturbance in the detected power grid frequency occurs (but the actual power grid frequency is not disturbed). Therefore, it is first determined whether there is a disturbance in the amplitude of the three-phase voltage at the point of common coupling. Then, steps S202 and S203 are performed when there is no disturbance. In this way, the problem of the misresponse of the inertia and the primary frequency regulation caused by the disturbance generated during the switching of the filter capacitor, sudden power increase, high-voltage ride-through, and low-voltage ride-through in detecting the power grid frequency and the change rate thereof based on the three-phase voltage signal of the power grid can be solved.

For example, the response condition for power grid frequency regulation may include: an inertia response condition and/or a primary frequency regulation response condition.

For example, it can be determined whether the inertia response condition is met based on the power grid frequency and the change rate of the power grid frequency, and it can be determine whether the primary frequency regulation response condition is met based on the power grid frequency.

When it is determined in step S202 that the response condition for power grid frequency regulation is met, step S203 is performed to control a power of a wind turbine to regulate the power grid frequency based on the power grid frequency and/or the change rate of the power grid frequency.

As an example, when only the inertia response condition is met, the inertia response may be performed by controlling the power of the wind turbine based on the change rate of the power grid frequency. For example, when only the primary frequency regulation response condition is met, the primary frequency regulation may be performed by controlling the power of the wind turbine based on the power grid frequency and the change rate thereof.

For example, when both the inertia response condition and the primary frequency regulation response condition are met, the inertia response may be preferentially performed by controlling the power of the wind turbine based on the change rate of the power grid frequency to provide active support for grid inertia. In other words, when both the inertia response condition and the primary frequency regulation response condition are met, the inertia response is preferentially performed, that is, the inertia response rather than the primary frequency regulation response is performed first at present.

It is considered in the present disclosure that in practice, the inertia response of the power grid often occurs before the primary frequency regulation. Moreover, the inertia response has a high time requirement of a millisecond level and has a short duration. While the primary frequency regulation response has a low time requirement of a second level, and has a long duration. Therefore, it is proposed in the present disclosure that, if the current power grid frequency or the change rate thereof meets the response condition, an active power increment shall be calculated based on the principle of preferentially performing the inertia response.

For example, when it is determined that there is no disturbance, it can be determined whether the power grid frequency and the change rate thereof are greater than a dead zone. When it is satisfied, it is determined whether a current power of the wind turbine is greater than 20% Pn. When it is greater than 20% Pn, it can be determined that the response condition for power grid frequency regulation is met. Then, the active power increment at the current power grid frequency and the change rate thereof may be calculated based on an virtual inertia equation.

For example, the inertia response condition may be set according to specific test standards, such as a determination condition for whether the inertia response acts is as shown in equation (5) below.

$$\Delta f \times \frac{df}{dt} > 0 \ \&\& \ \left| \frac{df}{dt} \right| > df_0 \tag{5}$$

where $\Delta f = f - f_N$, $f$ represents a detected power grid frequency, $f_N$ represents a rated frequency of the power grid, and $df_0$ represents a threshold of dead zone of the change rate of the frequency.

The primary frequency regulation response condition may also be set according to standard requirements. For example, as required by the national standard, in a case that the wind turbine is operating under a limited power frequency regulation condition and the active output is greater than 20% Pn, the wind turbine should be able to participate in system frequency regulation and allow system frequency recovery when a frequency deviation at a test point exceeds a threshold

(recommended $\pm$ 0.2Hz).

For example, the active power increment for the inertia response may be calculated according to equation (6) (as required by the national standard, the active power increment should be calculated according to the equation (6) to achieve the active support for the inertia response). It should be understood that the active power increment may be a positive value or a negative value.

$$\Delta P = -\frac{T_J}{f_N}\frac{df}{dt}P_N \qquad\qquad (6)$$

where $\Delta P$ represents the active power increment (i.e., a target value of the active power increment), $T_J$ represents an inertia time constant; $P_N$ represents a rated power of the generator set, $f_N$ represents a rated frequency of the power grid, and $df / dt$ represents a detected change rate of the power grid frequency.

In addition, for example, the active power increment may also be calculated according to the standard requirements for primary frequency regulation.

For example, a target value of the active power increment for the wind turbine may be determined based on the power grid frequency and/or the change rate of the power grid frequency; an additional torque value of the generator is calculated based on the target value of the active power increment and a rotation speed of the generator; a target torque value of the generator is calculate based on a torque value and the additional torque value of the generator; and a torque of the generator is controlled based on the target torque value of the generator to control the power of the wind turbine.

For example, the calculated target value of the active power increment may be uploaded to a main controller of the wind turbine (or a machine-side controller of the converter); the additional torque is calculated by the main controller of the wind turbine or the machine-side controller of the converter based on the target value of the active power increment and the rotation speed of the generator; the current torque can be superimposed by the main controller of the wind turbine or the machine-side controller of the converter to the additional torque value and the superimposed torque is sent to the machine-side controller of the converter for execution.

For example, in a solution for inertia response and primary frequency regulation response of a single machine for a direct-drive/semi-direct-drive wind turbine, the active power support increment may be calculated based on the power grid frequency detection with high-precision and the change rate thereof, and the whole generation set performs the power control based on the value of the active power increment.

For example, because the inertia response has a requirement for the response time and has a short duration, the active output of the wind turbine may be changed by using a control method of converting the active power increment into a kinetic energy of an impeller and a rotor to provide the active support for the inertia of the power grid. Because the inertia response has a requirement for the response time and has a short duration, the active output of the generation set may be changed by using a control method of converting the active power increment into a torque of a motor to provide the active support for the inertia of the power grid.

As an example, because the primary frequency regulation has a requirement for the response time and has a long duration, the active output of the wind turbine may be changed by the following two methods: (1) a method of adjusting an energy captured by the wind turbine to a wind energy by controlling a pitch angle, to allow the system to execute a demand value of the active power increment; (2) a control method of converting the active power increment into a kinetic energy of an impeller and a rotor, to provide the active support for the power grid frequency regulation. Alternatively, the active support for the primary frequency regulation may be achieved by a combination of the two methods. A longer response time is required when the active support for the primary frequency regulation is performed. On the one hand, the active support is provided with the kinetic energy of the rotor, that is, the active support is achieved by controlling the torque of the generator, sacrificing the stability of the rotation speed of the generator. At the same time, the active support may be achieved by changing an aerodynamic power of a wind turbine by pitching.

For example, the target value of the active power increment for the wind turbine may be determined based on the power grid frequency and/or the change rate of the power grid frequency; the value of the active power increment that needs to be regulated for each of multiple control cycles is determined based on the target value of the active power increment; and then, the power of the wind turbine is controlled based on the value of the active power increment that needs to be regulated for each control cycle. The multiple control cycles include a current control cycle and a certain number of subsequent control cycles. A sum of the values of the active power increment that need to be regulated for the multiple control cycles is the target value of the active power increment. According to this embodiment, the target value of the active power increment may be set according to a slope (i.e., regulating the power of the wind turbine in a small amount for multiple times), reducing the impact of power shock on the detection of the power grid frequency, and solving the problem of oscillation of the change rage of the power grid frequency and the active support due to the disturbance of the inertia response for the wind turbine during the active support on the frequency detection. In addition, setting the slope for the active power may also be achieved through low-pass filtering.

In addition, for example, the calculated target value of the active power increment may also be limited in amplitude, and the target value of the active power increment may be set according to the slope. The impact of power shock on the detection of the power grid frequency may be reduced by limiting the active power increment in amplitude and setting the active power increment according to the slope.

In addition, for example, the method for regulating a power grid frequency according to the embodiment of the present disclosure may further include: determining whether to exit a control mode of the inertia response and/or primary frequency regulation based on the power grid frequency and the change rate thereof. If it is determined to exit the control mode of the inertia response and/or primary frequency regulation, the target value of the active power increment may be set to 0, and the target value of the active power increment may be set according to the slope.

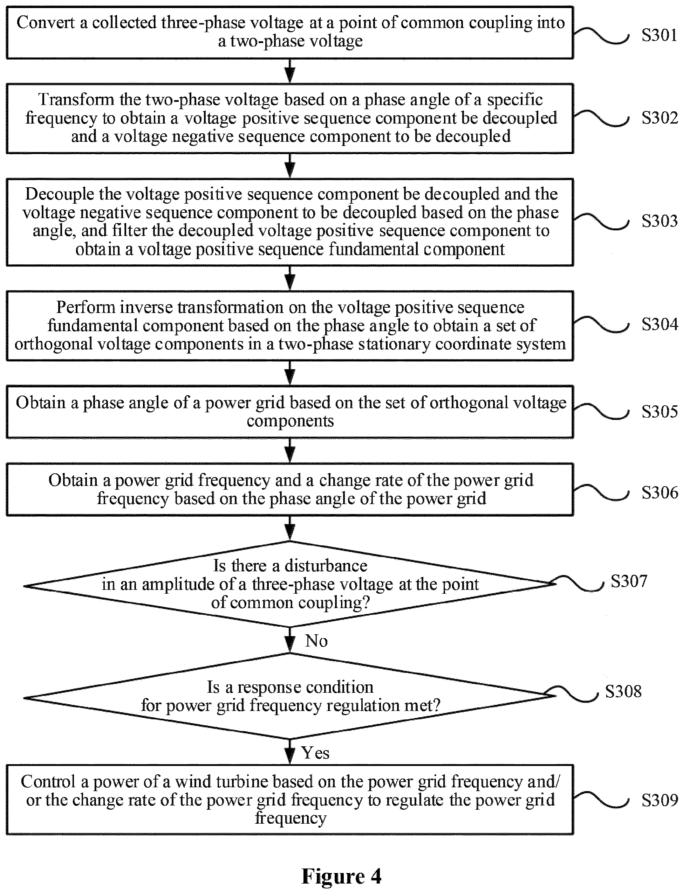

Figure 4 shows a flowchart of a method for regulating a power grid frequency according to another embodiment of the present disclosure.

In step S301, a collected three-phase voltage at a point of common coupling is converted into a two-phase voltage.

In step S302, the two-phase voltage is transformed based on a phase angle of a specific frequency to obtain a voltage positive sequence component to be decoupled and a voltage negative sequence component to be decoupled.

In step S303, the voltage positive sequence component to be decoupled and the voltage negative sequence component to be decoupled are decoupled based on the phase angle, and the decoupled voltage positive sequence component is filtered to obtain a voltage positive sequence fundamental component.

In step S304, an inverse transformation is performed on the voltage positive sequence fundamental component based on the phase angle to obtain a set of orthogonal voltage components in a two-phase stationary coordinate system.

In step S305, a phase angle of the power grid is obtained based on the set of orthogonal voltage components.

In step S306, a power grid frequency and a change rate of the power grid frequency are obtained based on the phase angle of the power grid.

In step S307, it is determined whether there is a disturbance in an amplitude of the three-phase voltage at the point of common coupling.

When it is determined in step S307 that there is no disturbance, step S308 is performed to determine whether a response condition for power grid frequency regulation is met based on the detected power grid frequency and/or the change rate of the power grid frequency.

When it is determined in step S308 that the response condition for power grid frequency regulation is met, step S309 is performed to control a power of the wind turbine based on the power grid frequency and/or the change rate of the power grid frequency to regulate the power grid frequency.

According to the embodiment of the present disclosure, the detection accuracy of the power grid frequency and the change rate of the power grid frequency may meet the following requirements: a measurement accuracy of the frequency is less than 0.001Hz and a measurement accuracy of the rate change of the frequency is less than 0.002Hz/s. The response time for the power grid frequency and the change rate of the power grid frequency may meet the following requirements: a detection time for the frequency and the change rate of the frequency is less than 100ms, and a total time for the inertia response is less than 500ms. A frequency offset may be adapted to a range of 40Hz to 70Hz for accurate detection. A voltage offset may be adapted to a range of 10% pu to 150% pu of the power grid voltage for accurate detection. A three-phase unevenness may be adapted to a case that the two-phase voltage drops to 10%pu, or the two-phase voltage rises to 150%pu, with the requirements for the detection accuracy of the frequency and the change rate of the frequency and the response time met. A voltage harmonic may be adapted to a case that a content of a single voltage harmonic of the 2nd, the 3rd, the 5th, the 7th and the like is less than 5%, or a total content of the harmonic is less than 5%, with the requirements for the detection accuracy of the frequency and the change rate of the frequency and the response time met. The adaptability of phase mutation may meet the requirements for the detection accuracy of the frequency and the change rate of the frequency and the response time. An accuracy of the active power control has an absolute value of an error not exceeding 2% Pn.

According to the embodiment of the present disclosure, the problem of the misresponse of the inertia and the primary frequency regulation caused by the disturbance generated during the switching of a filter capacitor, sudden power increase, high-voltage ride-through, and low-voltage ride-through in detecting the frequency and the change rate thereof based on the three-phase voltage signal of the power grid has been solved. In a case of adding no additional hardware to the wind turbine, the proposed method may be performed in the controller of the converter to achieve rapid development, application to new models, and on-site modification. The problem of oscillation of the change rate of the power grid frequency and the active support due to the disturbance of the inertia response for the wind turbine during the active support on the frequency detection is solved.

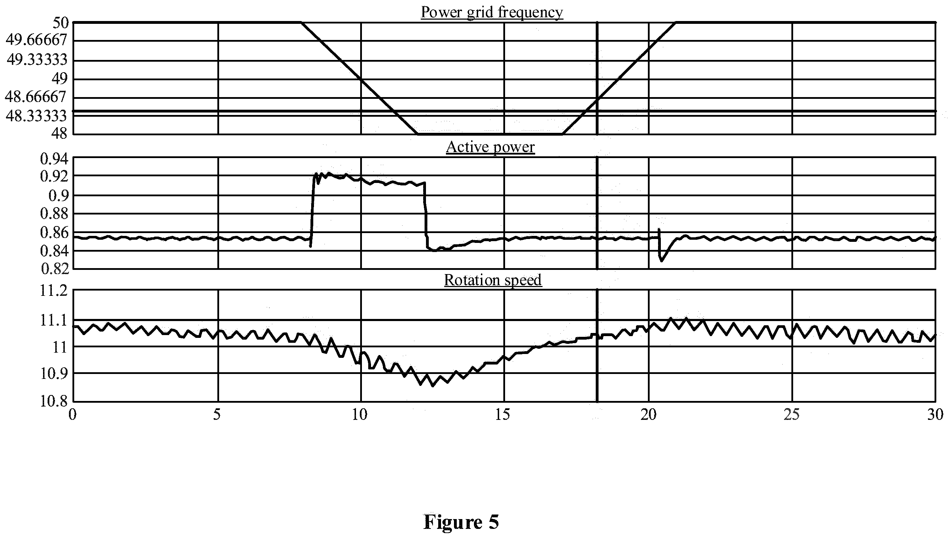

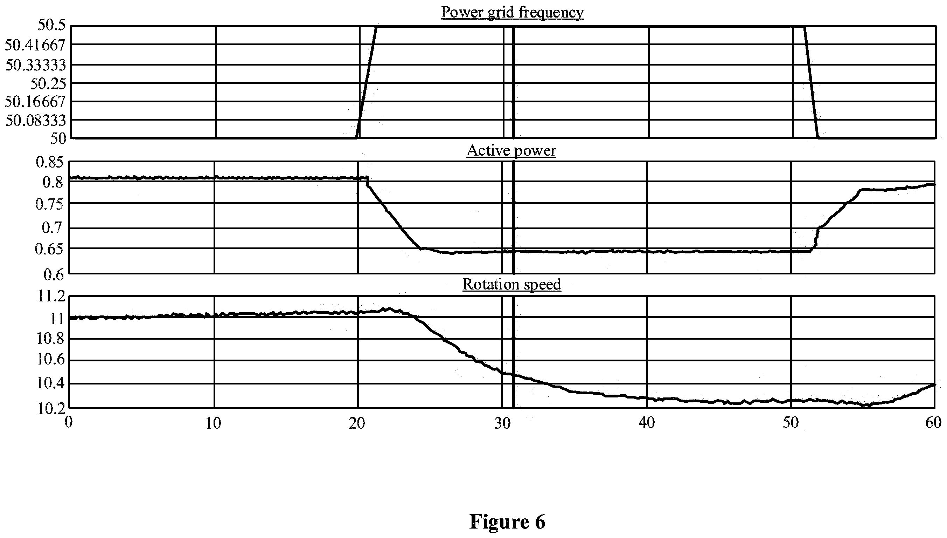

In combination to Figures 5 and 6, examples of an inertia response test and a primary frequency regulation test with the method for detecting a power grid frequency and the method for regulation a power grid frequency according to the embodiment of the present disclosure are provided.

Referring to a waveform of an inertia response test as shown in Figure 5, when the power grid frequency changes from 50Hz to 48Hz, the change rate of the power grid frequency is -0.5Hz/s. As shown in a first waveform in Figure 5, the calculated active power increment is 0.07Pn, and the actual waveform is a second waveform of Figure 5, where the active power increment increases from 0.85Pn to 0.92Pn. Because the active support is achieved through kinetic energy of a rotor, a rotation speed slowly decreases during the active support process, as shown in a third waveform of Figure 5. When the power grid frequency changes from 48Hz to 50Hz, the response condition is not met, and thus the active output for the generator set remains unchanged.

In a waveform of a primary frequency regulation test as shown in Figure 6, when the power grid frequency changes from 50Hz to 50.5Hz, as shown in a first waveform of Figure 6, a target value of the active power increment is -0.16Pn according to the requirements for the active power, and the actual waveform is a second waveform of Figure 6, where the active power increment increases from 0.81Pn to 0.65Pn. With action of a pitch, the rotation speed reaches a stable value, as shown in a third waveform of Figure 6. When the power grid frequency changes from 50.5Hz to 50Hz, the active output for the wind turbine begins to recover.

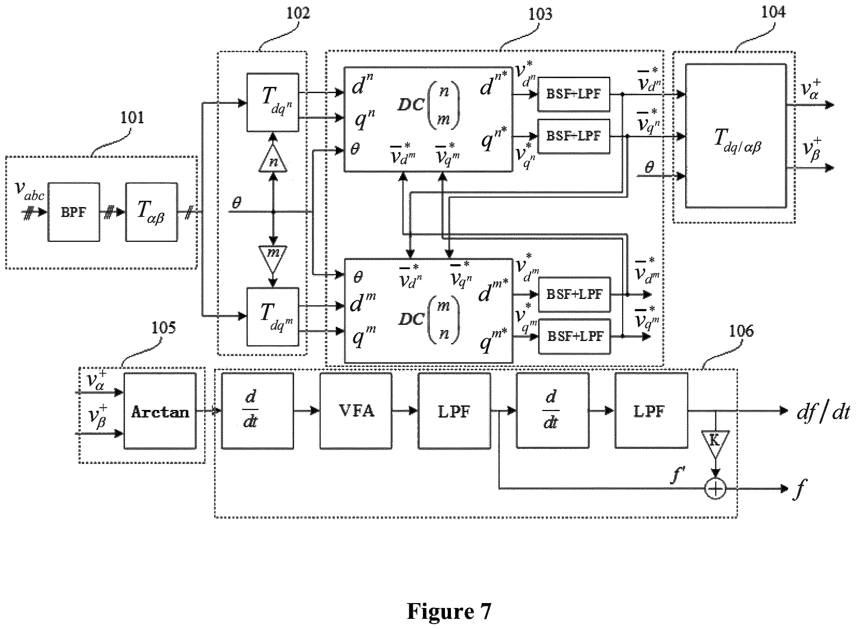

Figure 7 shows a structural block diagram of an apparatus for detecting a power grid frequency according to an embodiment of the present disclosure.

Referring to Figure 7, the apparatus for detecting a power grid frequency according to an embodiment of the present disclosure includes: a two-phase voltage acquisition unit 101, a transformation unit 102, a decoupling and filtering unit 103, an inverse transformation unit 104, a power grid phase angle acquisition unit 105, and a power grid frequency acquisition unit 106.

Specifically, the two-phase voltage acquisition unit 101 is configured to convert a collected three-phase voltage at a point of common coupling into a two-phase voltage.

The transformation unit 102 is configured to transform the two-phase voltage based on a phase angle of a specific frequency to obtain a voltage positive sequence component to be decoupled and a voltage negative sequence component to be decoupled.

The decoupling and filtering unit 103 is configured to decouple the voltage positive sequence component to be decoupled and the voltage negative sequence component to be decoupled based on the phase angle, and to filter the decoupled voltage positive sequence component to obtain a voltage positive sequence fundamental component.

The inverse transformation unit 104 is configured to perform inverse transformation on the voltage positive sequence fundamental component based on the phase angle to obtain a set of orthogonal voltage components in a two-phase stationary coordinate system.

The power grid phase angle acquisition unit 105 is configured to obtain a phase angle of the power grid based on the set of orthogonal voltage components.

The power grid frequency acquisition unit 106 is configured to obtain a power grid frequency based on the phase angle of the power grid.

As an example, the phase angle may be obtained by integrating a specific angular velocity. The frequency corresponding to the specific angular velocity is the specific frequency.

As an example, the two-phase voltage acquisition unit 101 may be configured to perform bandpass filtering on the collected three-phase voltage at the point of common coupling; and perform Clark equiamplitude transformation on the three-phase voltage subjected to bandpass filtering to obtain a two-phase voltage. A central frequency of the bandpass filtering is a rated frequency of the power grid or the power grid frequency detected during a previous detection cycle of the power grid frequency.

For example, the transformation unit 102 may be configured to perform positive and negative sequence rotation coordinate transformation on the two-phase voltage based on the phase angle, to obtain a voltage positive sequence component to be decoupled in a positive sequence rotation coordinate system and a voltage negative sequence component to be decoupled in a negative sequence rotation coordinate system. The positive sequence rotation coordinate system and the negative sequence rotation coordinate system form a dual synchronous rotation coordinate system.

As an example, the decoupling and filtering unit 103 may be configured to filter the decoupled voltage negative sequence component to obtain a voltage negative sequence fundamental component.

As an example, the decoupling and filtering unit 103 may be configured to perform cross feedback decoupling on the voltage positive sequence component to be decoupled based on the phase angle using the voltage negative sequence fundamental component obtained from a previous detection cycle of the power grid frequency to obtain a decoupled voltage positive sequence component, and perform cross feedback decoupling on the voltage negative sequence component to be decoupled based on the phase angle using the voltage positive sequence fundamental component obtained from a previous detection cycle of the power grid frequency to obtain a decoupled voltage negative sequence component.

As an example, the decoupling and filtering unit 103 may be configured to perform band-stop filtering and low-pass filtering on the decoupled voltage positive sequence component to obtain the voltage positive sequence fundamental component. A central frequency of the band-stop filtering is a rated frequency of the power grid or the power grid frequency detected during a previous detection cycle of the power grid frequency. The specific frequency is higher than a cut-off frequency of the low-pass filtering.

As an example, the power grid frequency acquisition unit 106 may be configured to perform differential calculation on the phase angle of the power grid to obtain a first frequency, filter the first frequency to obtain a second frequency, and obtain the power grid frequency based on the second frequency.

As an example, the apparatus for detecting a power grid frequency may further include: an acquisition unit(not shown) for a change rate of the power grid frequency. The acquisition unit is configured to perform differential calculation on the second frequency to obtain a change rate of the second frequency; and filter the change rate of the second frequency to obtain a change rate of the power grid frequency.

For example, the power grid frequency acquisition unit 106 may be configured to superimpose a product of the change rate of the power grid frequency and a frequency compensation coefficient onto the second frequency, and use a superimposed result as the power grid frequency.

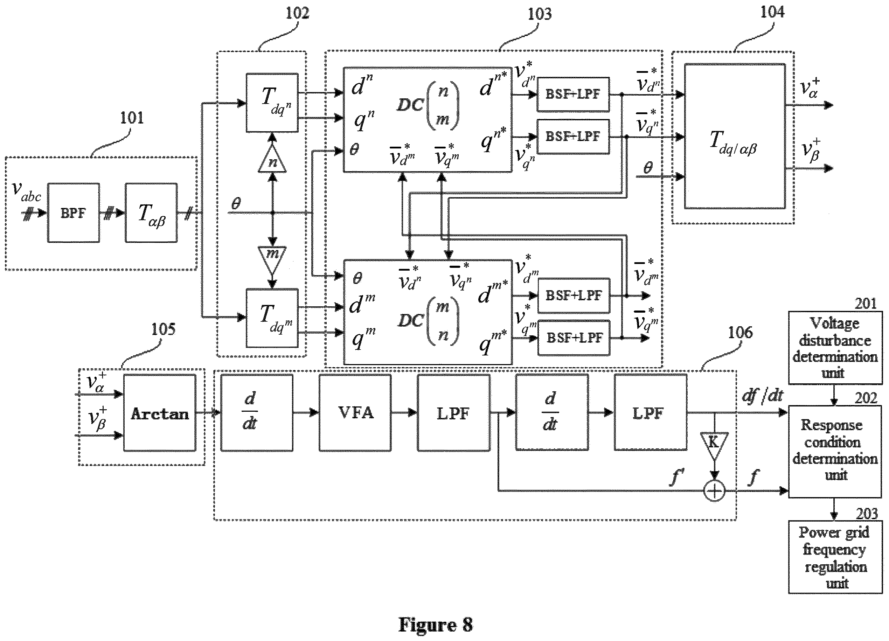

Figure 8 shows a structural block diagram of an apparatus for regulating a power grid frequency according to an embodiment of the present disclosure.

Referring to Figure 8, the apparatus for regulating a power grid frequency according to an embodiment of the present disclosure includes: a voltage disturbance determination unit 201, a response condition determination unit 202, and a power grid frequency regulation unit 203.

Specifically, the voltage disturbance determination unit 201 is configured to determine whether there is a disturbance in an amplitude of a three-phase voltage at a point of common coupling.

The response condition determination unit 202 is configured to determine whether a response condition for grid frequency regulation is met based on the detected power grid frequency and/or the change rate of the power grid frequency when there is no disturbance.

The power grid frequency regulation unit 203 is configured to control a power of a wind turbine based on the power grid frequency and/or the change rate of the power grid frequency when the response condition for grid frequency regulation is met, in order to regulate the power grid frequency.

The power grid frequency and/or the change rate of the power grid frequency are obtained through the apparatus for detecting a power grid frequency as described in the above embodiment.

As an example, the voltage disturbance determination unit 201 may be configured to determine whether there is a disturbance in the amplitude of the three-phase voltage at the point of common coupling based on the decoupled voltage positive sequence component and the voltage positive sequence fundamental component obtained by filtering the decoupled voltage positive sequence component. The decoupled voltage positive sequence component and the filtered voltage positive sequence fundamental component are obtained through the apparatus for detecting a power grid frequency as described in the above embodiment.

As an example, the voltage disturbance determination unit 201 may be configured to obtain an amplitude of a high-frequency signal in the decoupled voltage positive sequence component based on the decoupled voltage positive sequence component and the filtered voltage positive sequence fundamental component, and determine that there is a disturbance in the amplitude of the three-phase voltage at the point of common coupling when the amplitude of the high-frequency signal is greater than a preset threshold.

As an example, the response condition for power grid frequency regulation may include an inertia response condition and a primary frequency regulation response condition.

As an example, the response condition determination unit 202 may be configured to determine whether the inertia response condition is met based on the power grid frequency and the change rate of the power grid frequency, determine whether the primary frequency regulation response condition is met based on the power grid frequency. The power grid frequency regulation unit 203 may be configured to preferentially control a power of the wind turbine to perform the inertia response based on the change rate of the power grid frequency when both the inertia response condition and the primary frequency regulation response condition are met.

As an example, the grid frequency regulation unit 203 may be configured to determine a target value of an active power increment for the wind turbine based on the power grid frequency and/or the change rate of the power grid frequency; calculate an additional torque value of the generator based on the target value of the active power increment and a rotation speed of the generator; calculate a target torque value of the generator based on a torque value and the additional torque value of the generator; and control the torque of the generator based on the target torque value of the generator to control a power of the wind turbine.

As an example, the grid frequency regulation unit 203 may be configured to determine a target value of an active power increment for the wind turbine based on the power grid frequency and/or the change rate of the power grid frequency; determine a value of the active power increment that needs to be regulated for each of multiple control cycles based on the target value of the active power increment, where the multiple control cycles include a current control cycle and a subsequent control cycle; and control a power of the wind turbine based on the value of the active power increment that needs to be regulated for each control cycle, where a sum of values of the active power increment that needs to be regulated for the multiple control cycles is the target value of the active power increment.

It should be understood that the specific processes performed by the apparatus for detecting a power grid frequency and the apparatus for regulating a power grid frequency according to the embodiment of the present disclosure have been described in detail with reference to Figures 1 to 6, and relevant details will not be repeated here.

It should be understood that various units in the apparatus for detecting a power grid frequency and the apparatus for regulating a power grid frequency according to the embodiment of the present disclosure may be implemented in hardware components and/or software components. These skilled in the art may implement the various units for example by utilizing a field programmable gate array (FPGA) or an application specific integrated circuit (ASIC) based on the processes performed by various defined units.

A computer-readable storage medium storing a computer program is provided according to an embodiment of the present disclosure. The computer program, when executed by a processor, causes the processor to execute the method for detecting a power grid frequency and the method for regulating a power grid frequency as described in the above embodiment. The computer readable storage medium may be any data storage apparatus capable of storing data that is read by a computer system. Examples of the computer readable storage medium include: a read only memory, a random access memory, a read only optical disc, a magnetic tape, a floppy disk, an optical data storage apparatus, and a carrier wave (such as data transmission through the Internet via a wired or wireless transmission path).

The electronic device according to the embodiment of the present disclosure includes a processor (not shown) and a memory (not shown). The memory stores a computer program that, when executed by the processor, causes the processor to execute the method for detecting a power grid frequency and the method for regulating a power grid frequency as described in the above embodiment. As an example, the electronic device may be a controller of the wind turbine or a converter (e.g.,, a controller of the converter).

A computer program downloadable from a communication network and/or stored on a machine readable storage medium is provided according to an embodiment of the present disclosure. The computer program includes program code instructions for implementing the method for detecting a power grid frequency as described in the above embodiment and/or for implementing the method for regulating a power grid frequency as described in the above embodiment.

Although the present disclosure has been illustrated and described with reference to some embodiments thereof, it should be understood by those skilled in the art that various modifications may be made to the embodiments without departing from the principle and spirit of the present disclosure as defined in the claims and equivalents thereof.

## Claims

1. A method for detecting a power grid frequency, comprising:

   converting a collected three-phase voltage at a point of common coupling into a two-phase voltage;
   transforming the two-phase voltage based on a phase angle of a specific frequency to obtain a voltage positive sequence component to be decoupled and a voltage negative sequence component to be decoupled;
   decoupling the voltage positive sequence component to be decoupled and the voltage negative sequence component to be decoupled based on the phase angle, and filtering a decoupled voltage positive sequence component to obtain a voltage positive sequence fundamental component;
   performing inverse transformation on the voltage positive sequence fundamental component based on the phase angle to obtain a set of orthogonal voltage components in a two-phase stationary coordinate system;
   obtaining a phase angle of a power grid based on the set of orthogonal voltage components; and
   obtaining the power grid frequency based on the phase angle of the power grid.

2. The method for detecting a power grid frequency according to claim 1, wherein the phase angle is obtained by integrating a specific angular velocity, and a frequency corresponding to the specific angular velocity is the specific frequency.

3. The method for detecting a power grid frequency according to claim 1, wherein the converting the collected three-phase voltage at the point of common coupling into the two-phase voltage comprises:

   performing band-pass filtering on the collected three-phase voltage at the point of common coupling, wherein a center frequency of the band-pass filtering is a rated frequency of the power grid or a power grid frequency detected during a previous detection cycle of the power grid frequency; and
   performing Clark equiamplitude transformation on the three-phase voltage subjected to band-pass filtering to obtain the two-phase voltage.

**4.** The method for detecting a power grid frequency according to claim 1,
wherein the transforming the two-phase voltage based on the phase angle of the specific frequency to obtain the positive sequence component to be decoupled and the voltage negative sequence component to be decoupled comprises:

performing a positive and negative sequence rotation coordinate transformation on the two-phase voltage based on the phase angle to obtain a voltage positive sequence component to be decoupled in a positive sequence rotation coordinate system and a voltage negative sequence component to be decoupled in a negative sequence rotation coordinate system;
wherein the method for detecting a power grid frequency further comprises: filtering a decoupled voltage negative sequence component to obtain a voltage negative sequence fundamental component;
wherein the decoupling the voltage positive sequence component to be decoupled and the voltage negative sequence component to be decoupled based on the phase angle comprises:
performing cross feedback decoupling on the voltage positive sequence component to be decoupled based on the phase angle by using the voltage negative sequence fundamental component obtained from a previous detection cycle of the power grid frequency, to obtain a decoupled voltage positive sequence component;
performing cross feedback decoupling on the voltage negative sequence component to be decoupled based on the phase angle by using the voltage positive sequence fundamental component obtained from the previous detection cycle of the power grid frequency, to obtain a decoupled voltage negative sequence component;
wherein the positive sequence rotation coordinate system and the negative sequence rotation coordinate system form a dual synchronous rotation coordinate system.

**5.** The method for detecting a power grid frequency according to claim 1, wherein the filtering the decoupled voltage positive sequence component to obtain the voltage positive sequence fundamental component comprises:

performing band-stop filtering and low-pass filtering on the decoupled voltage positive sequence component to obtain the voltage positive sequence fundamental component;
wherein a central frequency of the band-stop filtering is a rated frequency of the power grid or a power grid frequency detected during a previous detection cycle of the power grid frequency; and
wherein the specific frequency is higher than a cut-off frequency of the low-pass filtering.

**6.** The method for detecting a power grid frequency according to any one of claims 1 to 5, wherein the obtaining the power grid frequency based on the phase angle of the power grid comprises:

performing differential calculation on the phase angle of the power grid to obtain a first frequency;
filtering the first frequency to obtain a second frequency; and
obtaining a power grid frequency based on the second frequency.

**7.** The method for detecting a power grid frequency according to claim 6, further comprising:

performing differential calculation on the second frequency to obtain a change rate of the second frequency; and
filtering the change rate of the second frequency to obtain a change rate of the power grid frequency.

**8.** The method for detecting a power grid frequency according to claim 7, wherein the obtaining the power grid frequency based on the second frequency comprises:
superimposing a product of the change rate of the power grid frequency and a frequency compensation coefficient to the second frequency, and using a superimposed result as the power grid frequency.

**9.** A method for regulating a power grid frequency, comprising:

determining whether there is a disturbance in an amplitude of a three-phase voltage at a point of common coupling;
determining, when there is no disturbance, whether a response condition for power grid frequency regulation is met based on a detected power grid frequency and/or a change rate of the power grid frequency; and
controlling, when the response condition for power grid frequency regulation is met, a power of a wind turbine based on the power grid frequency and/or the change rate of the power grid frequency to regulate the power grid frequency;
wherein the power grid frequency and/or the change rate of the power grid frequency are obtained by performing the method for detecting the power grid frequency according to any one of claims 1 to 8.

**10.** The method for regulating a power grid frequency according to claim 9, wherein the determining whether there is a disturbance in the amplitude of the three-phase voltage at the point of common coupling comprises:

determining whether there is a disturbance in the amplitude of the three-phase voltage at the point of common coupling based on the decoupled voltage positive sequence component and the voltage positive sequence fundamental component obtained by filtering the decoupled voltage positive sequence component;
wherein the decoupled voltage positive sequence component and the voltage positive sequence fundamental component after filtering are obtained by performing the method for detecting a power grid frequency according to any one of claims 1 to 8.

**11.** The method for regulating a power grid frequency according to claim 10, wherein the determining whether there is a disturbance in the amplitude of the three-phase voltage at the point of common coupling based on the decoupled voltage positive sequence component and the voltage positive sequence fundamental component obtained by filtering the decoupled voltage positive sequence component comprises:

obtaining an amplitude of a high-frequency signal in the decoupled voltage positive sequence component based on the decoupled voltage positive sequence component and the filtered voltage positive sequence fundamental component; and
determining there is a disturbance in the amplitude of the three-phase voltage at the point of common coupling when the amplitude of the high-frequency signal is greater than a preset threshold.

**12.** The method for regulating a power grid frequency according to claim 9, wherein the response condition for power grid frequency regulation comprise an inertia response condition and a primary frequency regulation response condition;
wherein the determining whether the response condition for power grid frequency regulation is met based on the detected power grid frequency and/or the change rate of the power grid frequency comprises:

determining whether the inertia response condition is met based on the power grid frequency and the change rate of the power grid frequency; and
determining whether the primary frequency regulation response condition is met based on the power grid frequency;
wherein the controlling, when the response condition for power grid frequency regulation is met, the power of the wind turbine based on the power grid frequency and/or the change rate of the power grid frequency to regulate the power grid frequency comprises:

performing the inertia response first by controlling the power of the wind turbine based on the change rate of the power grid frequency when both the inertia response condition and the primary frequency regulation response condition are met.

**13.** The method for regulating a power grid frequency according to claim 9, wherein the controlling the power of the wind turbine based on the power grid frequency and/or the change rate of the power grid frequency to regulate the power grid frequency comprises:

determining a target value of an active power increment for the wind turbine based on the power grid frequency and/or the change rate of the power grid frequency;
calculating an additional torque value of a generator based on the target value of the active power increment and a rotation speed of the generator;
calculating a target torque value of the generator based on a torque value and the additional torque value of the generator; and
controlling a torque of the generator based on the target torque value of the generator to control the power of the wind turbine.

**14.** The method for regulating a power grid frequency according to claim 9, wherein the controlling the power of the wind turbine based on the power grid frequency and/or the change rate of the power grid frequency to regulate the power grid frequency comprises:

determining a target value of an active power increment for the wind turbine based on the power grid frequency and/or the change rate of the power grid frequency;

determining a value of the active power increment that needs to be regulated for each of a plurality of control cycles based on the target value of the active power increment, wherein the plurality of control cycles comprises a current control cycle and a subsequent control cycle; and

controlling the power of the wind turbine based on the value of the active power increment that needs to be regulated for each control cycle;

wherein a sum of values of the active power increment that needs to be regulated for the plurality of control cycles is the target value of the active power increment.

15. An apparatus for detecting a power grid frequency, comprising:

a two-phase voltage acquisition unit, configured to convert a collected three-phase voltage at a point of common coupling into a two-phase voltage;

a transformation unit, configured to transform the two-phase voltage based on a phase angle of a specific frequency to obtain a voltage positive sequence component to be decoupled and a voltage negative sequence component to be decoupled;

a decoupling and filtering unit, configured to decouple the voltage positive sequence component to be decoupled and the voltage negative sequence component to be decoupled based on the phase angle, and to filter a decoupled voltage positive sequence component to obtain a voltage positive sequence fundamental component;

an inverse transformation unit, configured to perform inverse transformation on the voltage positive sequence fundamental component based on the phase angle to obtain a set of orthogonal voltage components in a two-phase stationary coordinate system;

a power grid phase angle acquisition unit, configured to obtain a phase angle of the power grid based on the set of orthogonal voltage components; and

a power grid frequency acquisition unit, configured to obtain the power grid frequency based on the phase angle of the power grid.

16. An apparatus for regulating a power grid frequency, comprising:

a voltage disturbance determination unit, configured to determine whether there is a disturbance in an amplitude of a three-phase voltage at a point of common coupling;

a response condition determination unit, configured to determine whether a response condition for power grid frequency regulation is met based on a detected power grid frequency and/or a change rate of the power grid frequency when there is no disturbance; and

a power grid frequency regulation unit, configured to control a power of a wind turbine based on the grid frequency and/or the change rate of the power grid frequency to regulate the power grid frequency when the response condition for power grid frequency regulation is met;

wherein the power grid frequency and/or the change rate of the power grid frequency are obtained by the apparatus for detecting the power grid frequency according to claim 15.

17. A computer-readable storage medium storing a computer program, wherein the computer program, when executed by a processor, causes the processor to perform the method for detecting a power grid frequency according to any one of claims 1 to 8 and/or the method for regulating a power grid frequency according to any one of claims 9 to 14.

18. An electronic device, comprising:

a processor; and

a memory, storing a computer program, wherein the computer program, when executed by the processor, causes the processor to perform the method for detecting a power grid frequency according to any one of claims 1 to 8 and/or the method for regulating a power grid frequency according to any one of claims 9 to 14.

Convert a collected three-phase voltage at a point of common coupling into a two-phase voltage — S101

Transform the two-phase voltage based on a phase angle of a specific frequency to obtain a voltage positive sequence component to be decoupled and a voltage negative sequence component to be decoupled — S102

Decouple the voltage positive sequence component to be decoupled and the voltage negative sequence component to be decoupled based on the phase angle, and filter the decoupled voltage positive sequence component to obtain a voltage positive sequence fundamental component — S103

Perform inverse transformation on the voltage positive sequence fundamental component based on the phase angle to obtain a set of orthogonal voltage components in a two-phase stationary coordinate system — S104

Obtain a phase angle of a power grid based on the set of orthogonal voltage components — S105

Obtain a power grid frequency based on the phase angle of the power grid — S106

**Figure 1**

**Figure 2**

EP 4 375 682 A1

Yes

Is there a disturbance
in an amplitude of a three-phase voltage
at a point of common coupling? — S201

No

No

Is a response condition
for power grid frequency regulation met? — S202

Yes

Control a power of a wind turbine based on the power grid
frequency and/or the change rate of the power grid frequency to
regulate the power grid frequency — S203

End

**Figure 3**

Convert a collected three-phase voltage at a point of common coupling into a two-phase voltage $\quad$ S301

Transform the two-phase voltage based on a phase angle of a specific frequency to obtain a voltage positive sequence component be decoupled and a voltage negative sequence component to be decoupled $\quad$ S302

Decouple the voltage positive sequence component be decoupled and the voltage negative sequence component to be decoupled based on the phase angle, and filter the decoupled voltage positive sequence component to obtain a voltage positive sequence fundamental component $\quad$ S303

Perform inverse transformation on the voltage positive sequence fundamental component based on the phase angle to obtain a set of orthogonal voltage components in a two-phase stationary coordinate system $\quad$ S304

Obtain a phase angle of a power grid based on the set of orthogonal voltage components $\quad$ S305

Obtain a power grid frequency and a change rate of the power grid frequency based on the phase angle of the power grid $\quad$ S306

Is there a disturbance in an amplitude of a three-phase voltage at the point of common coupling? $\quad$ S307

No

Is a response condition for power grid frequency regulation met? $\quad$ S308

Yes

Control a power of a wind turbine based on the power grid frequency and/ or the change rate of the power grid frequency to regulate the power grid frequency $\quad$ S309

**Figure 4**

Figure 5

**Figure 6**

EP 4 375 682 A1

**Figure 7**

Figure 8

## INTERNATIONAL SEARCH REPORT

| International application No. |
| --- |
| **PCT/CN2022/102858** |

| A. | CLASSIFICATION OF SUBJECT MATTER |
| --- | --- |

G01R 23/02(2006.01)i

According to International Patent Classification (IPC) or to both national classification and IPC

| B. | FIELDS SEARCHED |
| --- | --- |

Minimum documentation searched (classification system followed by classification symbols)

G01R 23/-

Documentation searched other than minimum documentation to the extent that such documents are included in the fields searched

Electronic data base consulted during the international search (name of data base and, where practicable, search terms used)

CNABS, WPI, EPODOC, CNKI: 新疆金风科技股份有限公司, 曹晓东, 电网, 频率, 三相, 两相, 正序, 负序, 解耦, 滤波, 电压, 反变换, 正交, 相角, electric network, three 3w phase, frequency, phase, angle, voltage?, positive, negative, sequence, filter +, decoupled

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 114280363 A (XINJIANG GOLDWIND SCIENCE & TECHNOLOGY CO., LTD.) 05 April 2022 (2022-04-05)<br>claims 1-18 | 1-18 |
| A | CN 110365018 A (NARI TECHNOLOGY CO., LTD. et al.) 22 October 2019 (2019-10-22)<br>description, paragraphs [0008]-[0085] | 1-18 |
| A | CN 102735938 A (NORTH CHINA ELECTRIC POWER UNIVERSITY (BAODING)) 17 October 2012 (2012-10-17)<br>entire document | 1-18 |
| A | CN 109358228 A (ZHANGJIAKOU INDUSTRIAL TECHNOLOGY RESEARCH INSTITUTE et al.) 19 February 2019 (2019-02-19)<br>entire document | 1-18 |
| A | CN 102305886 A (ZHEJIANG UNIVERSITY) 04 January 2012 (2012-01-04)<br>entire document | 1-18 |
| A | JP 2016224014 A (DAIHEN CORP.) 28 December 2016 (2016-12-28)<br>entire document | 1-18 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **02 September 2022** | **16 September 2022** |

| Name and mailing address of the ISA/CN | Authorized officer |
| --- | --- |
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/102858**

| Patent document cited in search report | | | Publication date (day/month/year) | Patent family member(s) | | | Publication date (day/month/year) |
|---|---|---|---|---|---|---|---|
| CN | 114280363 | A | 05 April 2022 | None | | | |
| CN | 110365018 | A | 22 October 2019 | CN | 110365018 | B | 29 March 2022 |
| CN | 102735938 | A | 17 October 2012 | None | | | |
| CN | 109358228 | A | 19 February 2019 | None | | | |
| CN | 102305886 | A | 04 January 2012 | CN | 102305886 | B | 24 July 2013 |
| JP | 2016224014 | A | 28 December 2016 | JP | 6423757 | B2 | 14 November 2018 |

Form PCT/ISA/210 (patent family annex) (January 2015)